# EUROPEAN PATENT SPECIFICATION

(11) **EP 3 428 981 B1**
(45) Date of publication and mention of the grant of the patent: **09.09.2020**
(21) Application number: 17763257.7
(22) Date of filing: 07.03.2017
(51) Int. Cl.: H01L 35/10, H01L 35/32, H01L 35/08

(54) **THERMOELECTRIC CONVERSION MODULE**
THERMOELEKTRISCHES UMWANDLUNGSMODUL
MODULE DE CONVERSION THERMOÉLECTRIQUE

(30) Priority: 10.03.2016 JP 2016047300
(43) Date of publication of application: 16.01.2019
(73) Proprietor: Atsumitec Co., Ltd., Hamamatsu-shi, Shizuoka 433-8118 (JP)
(72) Inventor: UCHIYAMA, Naoki, Hamamatsu-shi Shizuoka 433-8118 (JP); KUBO, Kazuya, Hamamatsu-shi Shizuoka 433-8118 (JP)
(74) Representative: Blumbach · Zinngrebe Patentanwälte PartG mbB
(86) International application number: PCT/JP2017/009040
(87) International publication number: WO 2017/154917

(56) References cited:
- WO-A1-2015/111628
- JP-A- 2000 252 528
- JP-A- 2001 244 510
- JP-A- 2012 235 088

## Description

### Technical Field

The present invention relates to a thermoelectric conversion module which generates electricity by thermoelectric conversion based on the Seebeck effect.

### Background Art

The thermoelectric conversion module is a module comprising thermoelectric conversion elements capable of converting thermal energy into electrical energy through the Seebeck effect. Thermoelectric conversion modules and thermoelectric conversion elements for forming them are attracting attention as environmentally-friendly energy-saving technology, because they can convert waste heat, expelled from industrial or consumer processes or moving vehicles, into available electrical energy by making use of the energy conversion property.

Such thermoelectric conversion modules are commonly formed by connecting thermoelectric conversion elements (p-type and n-type semiconductor elements) by electrodes. A thermoelectric conversion module of this type is disclosed in Patent Document 1, for example. The thermoelectric conversion module in Patent Document 1 comprises a pair of substrates, a plurality of thermoelectric conversion elements which are electrically connected to first electrodes arranged on one of the substrates at their first ends, and to second electrodes arranged on the other substrate at their opposite, second ends, and connectors each electrically connecting the first electrode connected to a thermoelectric conversion element to the second electrode connected to an adjacent thermoelectric conversion element. Furthermore, JP 2000 252528 A discloses a thermoelectric generating module with a row of P and N type thermoelements alternately arranged with high and low temperature side electrodes, and copper coated flat lead end electrodes on a low temperature side.

### Prior Art Document

### Patent Document

Patent Document 1: Japanese Unexamined Patent Application Publication No. 2013-115359

### Summary of the Invention

### Problems to be solved by the Invention

However, when the thermoelectric conversion module configured as disclosed in Patent Document 1 is applied to a heat source such as an exhaust system of an engine, the substrate contacting the heat source may be distorted or curved by thermal expansion when the amount of heat is increased by an increase in the amount of exhaust gas from the engine. When the substrate is distorted or curved, stress is concentrated on extraction terminals of the thermoelectric conversion module or electrodes and joints near the extraction terminals (i.e. near the front and rear ends of the thermoelectric conversion module), which may cause the extraction terminals to separate from the corresponding thermoelectric conversion elements or cause the electrodes near the extraction terminals to separate from the joints. Such separation causes variations in internal resistance and voltage of the thermoelectric conversion module, leading to decrease in reliability.

The present invention has been made in view of the above problem. An object of the present invention is to provide a thermoelectric conversion module which can prevent separation of electrodes, etc. regardless of use conditions and realize high reliability.

### Means for Solving the Problems

In order to achieve the above object, the thermoelectric conversion module according to the present invention comprises a plurality of thermoelectric conversion elements arranged adjacent to each other, first electrodes joined to first ends of the thermoelectric conversion elements to electrically connect the first ends of adjacent thermoelectric conversion elements, and second electrodes joined to opposite, second ends of the thermoelectric conversion elements to electrically connect the second ends of adjacent thermoelectric conversion elements, wherein the thermoelectric conversion elements electrically connected by the first and second electrodes form at least one series circuit element, and third electrodes having flexibility are provided at ends of the series circuit element, and further comprises: a first covering layer provided to cover the first electrodes in a manner that the first electrodes are buried therein, and a second covering layer provided to cover the third electrodes, the thermoelectric conversion elements, and the second electrodes in a manner that they are buried therein, wherein the first covering layer and the second covering layer contain a material functioning as a thermally-conductive material, and wherein the second covering layer is lower in thermal conductivity than the first covering layer.

### Advantageous Effects of the Invention

The thermoelectric conversion module according to present invention can prevent separation of electrodes, etc. regardless of use conditions and realize high reliability.

### Brief Description of the Drawings

FIG. 1 is a perspective view of a thermoelectric conversion module according to an embodiment.
FIG. 2 is a top view of the thermoelectric conversion module according to the embodiment.
FIG. 3 is a cross-sectional view of the thermoelectric conversion module along line III-III in FIG. 2.
FIG. 4 is a side view of an electrode for use in the thermoelectric conversion module according to the embodiment.
FIG. 5 is a graph showing variations in voltage in a thermoelectric conversion module observed in test.
FIG. 6 is a graph showing variations in voltage in a comparative example observed in test.

### Mode of Carrying out the Invention

With reference to the accompanying drawings, how to carry out the thermoelectric conversion module according to the present invention will be described in detail based on an embodiment. The drawings used in explanation of the embodiment show the thermoelectric conversion module according to the present invention and its components, schematically; in order to help understanding, the drawings may contain partial emphasis, enlargement, contraction, omission or the like, and thus, may not necessarily show the components on an accurate scale and in an accurate shape. Further, numerical values mentioned in connection with the embodiment are all given by way of example; they may be varied as necessary.

### (Embodiment)

### (Configuration of a thermoelectric conversion module)

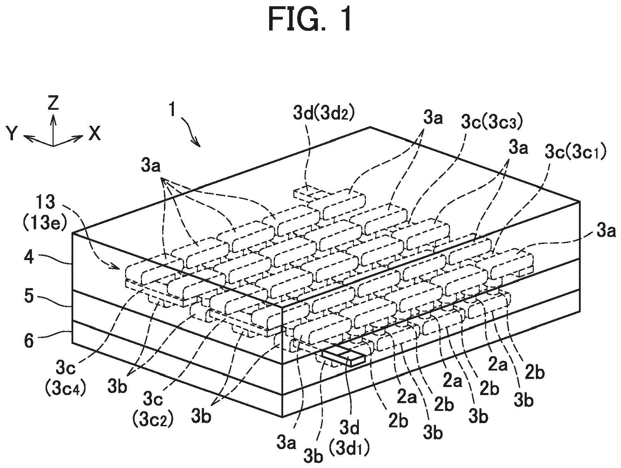

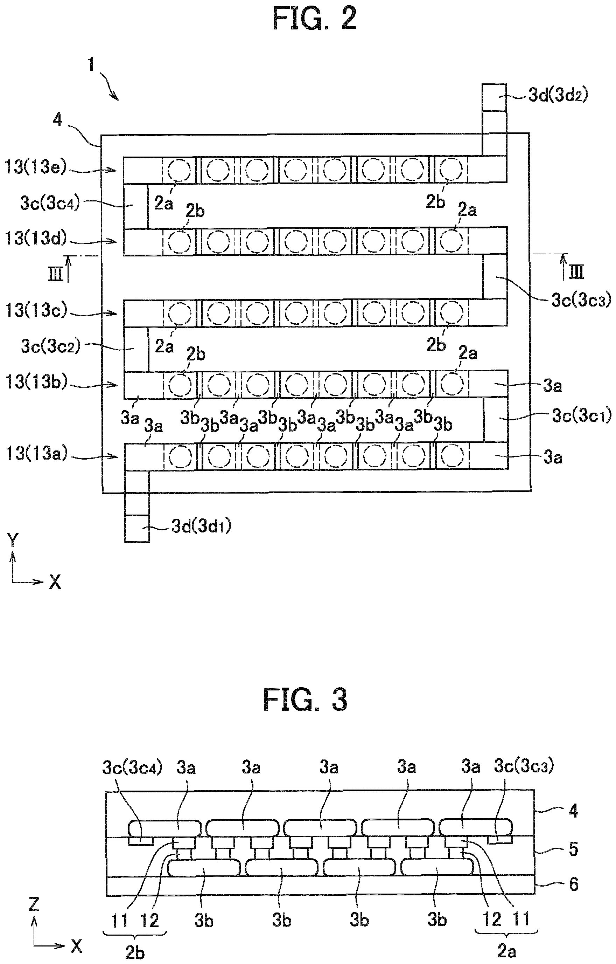

With reference to FIGS. 1 to 3, a thermoelectric conversion module 1 according to an embodiment will be described. FIG. 1 is a perspective view of the thermoelectric conversion module 1 according to the embodiment. FIG. 2 is a top view of the thermoelectric conversion module 1 according to the embodiment. FIG. 3 is a cross-sectional view of the thermoelectric conversion module along line III-III in FIG. 2. In FIG. 1, one direction is referred to as X direction, and directions perpendicular to X direction are referred to as Y direction and Z direction. Specifically, the direction parallel to the height of the thermoelectric conversion module 1 is referred to as Z direction.

As seen from FIGS. 1 to 3, the thermoelectric conversion module 1 according to the present embodiment comprises first and second thermoelectric conversion elements 2a, 2b arranged adjacent to each other, and first and second electrodes 3a, 3b joined to the opposite ends of the first and second thermoelectric conversion elements 2a, 2b. The thermoelectric conversion module 1 according to the present embodiment further comprises connecting electrodes 3c which connect the first electrodes 3a located at each X-way end of the thermoelectric conversion module 1 to each other, and extraction electrodes 3d which function as external connection electrodes of the thermoelectric conversion module 1. The thermoelectric conversion module 1 according to the present embodiment further comprises a first covering layer 4 provided to cover the first electrodes 3a, a second covering layer 5 provided to cover the first and second thermoelectric conversion elements 2a, 2b and the connecting electrodes 3c, and a support substrate 6 provided to support the second electrodes 3b.

When mentioning the individual connecting electrodes 3c, they will be referred to as connecting electrode 3c₁, connecting electrode 3c₂, connecting electrode 3c₃ and connecting electrode 3c₄, and when mentioning the individual extraction electrodes 3d, they will be referred to as extraction electrode 3d₁ and extraction electrode 3d₂..

In the present embodiment, the first thermoelectric conversion elements 2a are made of an n-type semiconductor material, and the second thermoelectric conversion elements 2b are made of a p-type semiconductor material. The first and second thermoelectric conversion elements 2a, 2b are arranged alternately in a matrix (eight in X direction, five in Y direction, forty in all), where adjacent first and second thermoelectric conversion elements 2a, 2b are electrically connected by first and second electrodes 3a, 3b. In the present embodiment, the first thermoelectric conversion element 2a as well as the second thermoelectric conversion element 2b has a shape consisting of two cylinders of different diameter joined together, as shown in FIG. 3. More specifically, as shown in FIG. 3, the first thermoelectric conversion element 2a as well as the second thermoelectric conversion element 2b consists of a first cylindrical portion 11 with a large diameter (5mm in diameter, for example) adjacent to the first electrode 3a and a second cylindrical portion 12 with a small diameter (3mm in diameter, for example) adjacent to the second electrode 3b. The first and second thermoelectric conversion element 2a, 2b are not limited to this shape. They may be in the shape of a circular cylinder or a quadrangular prism, for example.

The first electrode 3a and the second electrode 3b are of the same shape (plate-like shape) and made of copper, for example. The first electrodes 3a are arranged such that five are arranged in a row in X direction and five are arranged in a row in Y direction (thus, twenty-five in all). The first electrodes 3a located at the X-way ends are each joined to a first thermoelectric conversion element 2a or a second thermoelectric conversion element 2b, at an end, and joined to a connecting electrode 3c or an extraction electrode 3d, at the opposite end. Meanwhile, the second electrodes 3b are arranged such that four are arranged in a row in X direction and five are arranged in a row in Y direction (thus, twenty in all). The second electrodes 3b are each joined to a first thermoelectric conversion element 2a, at an end, and joined to a second thermoelectric conversion element 2b, at the opposite end. As seen from FIGS. 1 and 3, the first and second thermoelectric conversion elements 2a, 2b are sandwiched between the first electrodes 3a and the second electrodes 3b in Z direction.

As a result of this arrangement of the first and second thermoelectric conversion elements 2a, 2b and the first and second electrodes 3a, 3b, the first and second thermoelectric conversion elements 2a, 2b are connected in series. Particularly in the present embodiment, four first thermoelectric conversion elements 2a, four second thermoelectric conversion elements 2b, five first electrodes 3a and four second electrodes 3b arranged in a X-way row form a series circuit element 13. Accordingly, the thermoelectric conversion module 1 contains five series circuit elements 13 in all. Series circuit elements 13 adjacent to each other in Y direction are connected by a connecting electrode 3c at an end. When mentioning the individual series circuit elements 13, they will be referred to as series circuit element 13a, series circuit element 13b, series circuit element 13c, series circuit element 13d and series circuit element 13e.

The first electrode 3a as well as the second electrode 3b is not limited to a copper plate; they may be made of another electrically-conductive material (metal such as aluminum, for example). The number and shape of the first and second electrodes 3a, 3b are not limited to the above but may be changed appropriately depending on the first and second thermoelectric conversion elements 2a, 2b (in other words, the magnitude of electromotive force). Further, the first and second electrodes 3a, 3b may be arranged to connect the first and second thermoelectric conversion elements 2a, 2b in parallel.

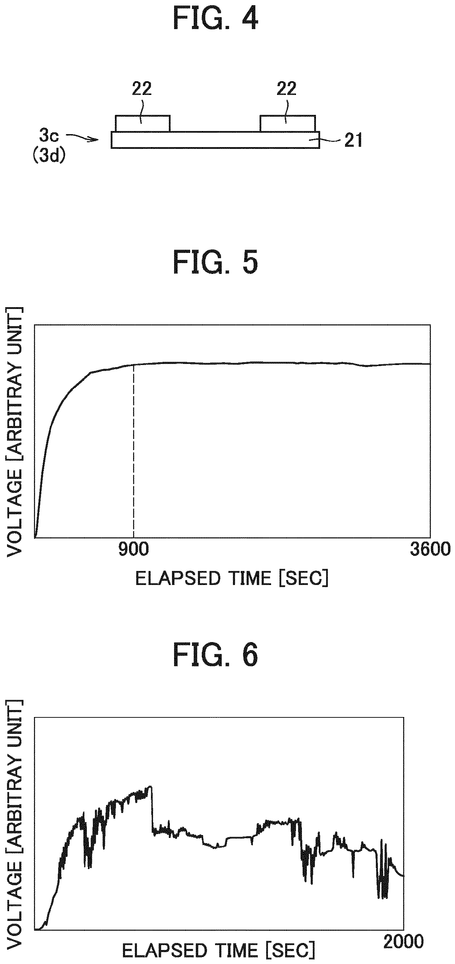

The connecting electrode 3c and the extraction electrode 3d are identical in structure. Specifically, as shown in FIG. 4, they are each composed of a metal mesh 21 and two metal plates 22 fixed to the metal mesh 21 at opposite ends. The connecting electrode 3c and the extraction electrode 3d, which include a metal mesh 21 with high flexibility, have flexibility. The ratio of openings and the size of the opening in the metal mesh 21 may be selected appropriately to ensure that the connecting electrode 3c and the extraction electrode 3d have high flexibility.

Although in the present embodiment, the metal mesh 21 and the metal plate 22 are made of copper, they are not limited to copper but may be made of another metal. Particularly, materials that can provide high electrical conductivity while ensuring high flexibility of the connecting electrode 3c and the extraction electrode 3d are desirable. The connecting electrode 3c and the extraction electrode 3d do not necessarily need to contain a metal mesh 21 if they can have high flexibility; they may be formed using a metallic material having a structure other than mesh.

As shown in FIG. 2, to a series circuit element 13a with a -Y-side extraction electrode 3d₁ joined at an end, a connecting electrode 3c₁ is joined at the opposite (+X-side) end, and the connecting electrode 3c₁ connects the series circuit element 13a to a +Y-side adjacent series circuit element 13b. To the series circuit element 13b, a connecting electrode 3c₂ is joined at a (-X-side) end opposite to the end connected to the series circuit element 13a, and the connecting electrode 3c₂ connects the series circuit element 13b to a +Y-side adjacent series circuit element 13c. In like manner, the series circuit element 13c is connected to a series circuit element 3d at a +X-side end by a connecting electrode 3c₃, and the series circuit element 13d is connected to a series circuit element 13e at a -X-side end by a connecting electrode 3c₄. To the series circuit element 13e, an extraction electrode 3d₂ is joined at a +X-side end.

In the thermoelectric conversion module 1, the series circuit elements 13 connected to each other by the connecting electrodes 3c in this manner form a zigzag series circuit. The series circuit is provided with the extraction electrodes 3d for external connection, at the opposite ends, which enable electricity generated by the thermoelectric conversion module 1 to be extracted externally. To form the zigzag series circuit, the first and second thermoelectric elements 2a, 2b forming the series circuit elements 13b, 13d alternate in reverse order, as compared with those forming the series circuit elements 13a, 13c, 13e.

As seen from FIGS. 1 and 3, the first covering layer 4 covers the surfaces of the first electrodes 3a in a manner that the first electrodes 3a are buried therein. The first covering layer 4 is made of an insulating resin mixed with a metallic material functioning as a thermally-conductive material, such as aluminum, copper or aluminum nitride. The first covering layer 4 made of such mixture has a relatively high thermal conductivity and provides good electrical insulation around the first electrodes 3a.

As seen from FIGS. 1 to 3, the second covering layer 5 covers the first and second thermoelectric conversion elements 2a, 2b, the second electrodes 3b and the connecting electrodes 3c in a manner that the first and second thermoelectric conversion elements 2a, 2b, the second electrodes 3b and the connecting electrodes 3c are buried therein. The second covering layer 5 is made of an insulating resin mixed with a heat-insulating material. Heat-insulating materials usable for the second covering layer 5 include fibrous heat-insulating materials such as glass wool, and foam heat-insulating materials such as polystyrene foam.

The second covering layer 5 made of such mixture is lower in thermal conductivity than the first covering layer 5 and has a function of suppressing dissipation of heat from the first and second thermoelectric conversion elements 2a, 2b, the second electrodes 3b and the connecting electrodes 3c. Accordingly, the second covering layer 5 helps increase a temperature difference between the first electrodes 3a and the second electrodes 3b and keeps the temperature difference constant, thereby enabling greater electromotive force to be produced. The second covering layer 5 also provides good electrical insulation around the first and second thermoelectric conversion elements 2a, 2b, the second electrodes 3b and the connecting electrodes 3c.

Further, the second covering layer 5 holds the first and second thermoelectric conversion elements 2a, 2b, the second electrodes 3b and the connecting electrodes 3c relatively firmly, leading to an increased strength of the thermoelectric conversion module 1. Further, the first and second thermoelectric conversion elements 2a, 2b are completely covered, and thus, prevented from getting broken, tainted or something, which suppresses a decrease in thermoelectric conversion efficiency and reliability of the thermoelectric conversion module 1. Further, none of the joint surfaces between the first or second thermoelectric conversion element 2a, 2b and the first or second electrode 3a, 3b have an exposed edge. This increases the joint strength between the thermoelectric conversion elements and the electrodes, keeps down a decrease in joint strength due to aging, and prevents production of cracks at the joint surfaces.

The second covering layer 5 does not necessarily need to cover the first and second thermoelectric conversion elements 2a, 2b completely but may cover them partly, because also in that case, the second covering layer can produce a temperature difference between the first electrodes 3a and the second electrodes 3b, keep the temperature difference constant, and increase the strength of the thermoelectric conversion module 1. Like the first covering layer 4, the second covering layer 5 may contain a material functioning as a thermally-conducive material, although it is required that the second covering layer 5 be lower in thermal conductivity than the first covering layer 4. Although in the described example, the chief material for the first and second covering layers 4, 5 is a resin, it may be a ceramic or the like. Also in that case, it is required that the material covering the second electrodes 3b be lower in thermal conductivity than the material covering the first electrodes 3a.

As shown in FIGS. 1 and 3, the support substrate 6 is joined to the second electrodes 3b to support the second electrodes 3b. The support substrate 6 is made of an insulating material. The support substrate 6 may be a common insulating substrate such as a qlass epoxy substrate.

### (Method for fabricating a thermoelectric conversion module)

A method for fabricating a thermoelectric conversion module 1 according to this embodiment is as follows: First thermoelectric conversion elements 2a, second thermoelectric conversion elements 2b, first electrodes 3a, second electrodes 3b, connecting electrodes 3c and extraction electrodes 3d are prepared and arranged between two punches functioning as conducting pressing members in a fabricating apparatus. Then, pressure is applied by pressing the punches to the first thermoelectric conversion elements 2a, second thermoelectric conversion elements 2b, first electrodes 3a, second electrodes 3b, connecting electrodes 3c and extraction electrodes 3d arranged between them while current is applied. As a result, the first electrodes 3a, the second electrodes 3b, the connecting electrodes 3c and the extraction electrodes 3d are diffusion-bonded (plasma-bonded) to the first and second thermoelectric conversion elements 2a, 2b, so that the first and second thermoelectric conversion elements 2a, 2b are connected in series, thus forming a series circuit including five series circuit elements 13. The application of pressure and current is performed within a vacuum chamber or a chamber with a nitrogen gas atmosphere or an inert gas atmosphere.

Next, the first and second thermoelectric conversion elements 2a, 2b with the first electrodes 3a, second electrodes 3b, connecting electrodes 3c and extraction electrodes 3d joined are mounted on a support substrate 6. More specifically, they are mounted with the second electrodes 3b bonded to a metal pattern formed on the support substrate 6 by a bonding material such as solder. The support substrate 6 thus supports the first and second thermoelectric conversion elements 2a, 3b with the first electrodes 3a, second electrodes 3b, connecting electrodes 3c and extraction electrodes 3d joined.

Next, a second covering layer 5 is formed by common insert molding, and then a first covering layer 4 is formed by insert molding, likewise. By this process, the thermoelectric conversion module 1 is completed..

### (Comparison between an example according to the embodiment and a comparative example)

Next, with reference to FIGS. 5 and 6, test performed on a thermoelectric conversion module 1 according to the above embodiment and a thermoelectric conversion module prepared as a comparative example (hereinafter referred to as "comparative example"), and the result of the test will be described. The comparative example differs from the thermoelectric conversion module 1 according to the embodiment in that for the connecting electrodes 3c and the extraction electrodes 3b, non-flexible plate-like metal electrodes are used.

FIGS. 5 and 6 are graphs showing variations in voltage for the thermoelectric conversion module 1 and the comparative example, respectively, observed in test specified below. In FIGS. 5 and 6, voltage is plotted on the vertical axis (in arbitrary unit) and elapsed time is plotted on the horizontal axis (in second). The test was performed by applying the thermoelectric conversion module 1 and the comparative example to a utility engine (400cc·3700rpm) prepared as a heat source to check durability. In the test, cooling was performed using a water-cooled chiller (set to - 20°C, flowrate: 4.5L/min).

As seen from comparison between FIGS. 5 and 6, in the thermoelectric conversion module 1 according to the embodiment, voltage increases up to the elapsed time about 900sec, and then becomes stable and does not exhibit variations. In the comparative example, by contrast, voltage gradually increases and does not become stable but repeats great variations up to the elapsed time about 2000sec. The reason for this difference is: in the thermoelectric conversion module 1 according to the embodiment, the connecting electrodes 3c and extraction electrodes 3d having flexibility are joined at the ends of the series circuit elements 13, and they do not separate from the first electrodes 3a even when an increase in temperature of the thermoelectric conversion module 1 brings about stress concentration. In the comparative example, by contrast, non-flexible plate-like electrodes are joined at the ends of the series circuit elements 13, and an increase in temperature causes the non-flexible electrodes to separate from the first electrodes 3a, resulting in greatly-varying, unstable voltage.

As described above, in the present embodiment in which the connecting electrodes 3c and extraction electrodes 3d having flexibility are joined at the ends of the series circuit elements 13, the connecting electrodes 3c and extraction electrodes 3d do not separate from the first electrodes 3a even when an increase in temperature of the thermoelectric conversion module 1 brings about stress concentration. Further, when installed in a vehicle, the thermoelectric conversion module 1 configured as described above can prevent electrode separation due to vibration of the engine. The thermoelectric conversion module 1 according to this embodiment can thus prevent separation of electrodes, etc. regardless of use conditions and realize high reliability.

Although the described embodiment has a plurality of series circuit elements 13, it may have only one series circuit element 13, where the extraction electrodes 3d are provided at the opposite ends thereof. Also in this case, the influence of distortion caused by stress produced at the opposite ends of the thermoelectric conversion module 1 is reduced. Accordingly, separation of the extraction electrodes 3d can be prevented regardless of use conditions, leading to high reliability.

Although in the described embodiment, metal plates are used for the first and second electrodes 3a, 3b, the first and second electrodes 3a, 3b may be flexible electrodes like the connecting electrode 3c and the extraction electrode 3d. In that case, the influence of distortion caused by stress is reduced, not only at the ends of the thermoelectric conversion module but all over the area where the electrodes are present.

### Explanation of Reference Signs

- 1: Thermoelectric conversion module
- 2a: First thermoelectric conversion element
- 2b: Second thermoelectric conversion element
- 3a: First electrode
- 3b: Second electrode
- 3c: Connecting electrode (third electrode)
- 3d: Extraction electrode (third electrode)
- 4: First covering layer
- 5: Second covering layer
- 6: Support substrate
- 11: First cylindrical portion
- 12: Second cylindrical portion
- 13: Series circuit element

## Claims

1. A thermoelectric conversion module (1), comprising
a plurality of thermoelectric conversion elements (2a, 2b) arranged adjacent to each other, first electrodes (3a) joined to first ends of the thermoelectric conversion elements (2a, 2b) to electrically connect the first ends of adjacent thermoelectric conversion elements (2a, 2b), and
second electrodes (3b) joined to opposite, second ends of the thermoelectric conversion elements (2a, 2b) to electrically connect the second ends of adjacent thermoelectric conversion elements (2a, 2b), wherein
the thermoelectric conversion elements (2a, 2b) electrically connected by the first and second electrodes (3a, 3b) form at least one series circuit element, and
third electrodes (3c) having flexibility are provided at ends of the series circuit element (13), further comprising:
a first covering layer (4) provided to cover the first electrodes (3a) in a manner that the first electrodes (3a) are buried therein, and
a second covering layer (5) provided to cover the third electrodes (3c), the thermoelectric conversion elements (2a, 2b), and the second electrodes (3b) in a manner that they are buried therein,
wherein the first covering layer (4) and the second covering layer (5) contain a material functioning as a thermally-conductive material, and wherein the second covering layer (5) is lower in thermal conductivity than the first covering layer (4).

2. The thermoelectric conversion module (1) according to claim 1, comprising a plurality of the series circuit elements (13), wherein
the series circuit elements (13) are connected to each other by the third electrodes (3c).

3. The thermoelectric conversion module (1) according to claim 1 or 2, wherein the third electrode (3c) includes a metal mesh.

4. The thermoelectric conversion module (1) according to claim 3, wherein the third electrode (3c) includes metal plates fixed to the metal mesh at opposite ends.

5. The thermoelectric conversion module (1) according to any one of claims 1 to 4, wherein the first and second electrodes (3a, 3b) have flexibility.

## Patentansprüche

1. Thermoelektrisches Umwandlungsmodul (1), umfassend
eine Mehrzahl von nebeneinander angeordneten thermoelektrischen Umwandlungselementen (2a, 2b),
erste Elektroden (3a), die mit ersten Enden der thermoelektrischen Umwandlungselemente (2a, 2b) verbunden sind, um die ersten Enden benachbarter thermoelektrischer Umwandlungselemente (2a, 2b) elektrisch zu verbinden, und
zweite Elektroden (3b), die mit entgegengesetzten, zweiten Enden der thermoelektrischen Umwandlungselemente (2a, 2b) verbunden sind, um die zweiten Enden benachbarter thermoelektrischer Umwandlungselemente (2a, 2b) elektrisch zu verbinden, wobei
die durch die ersten und zweiten Elektroden (3a, 3b) elektrisch verbundenen thermoelektrischen Umwandlungselemente (2a, 2b) mindestens ein Reihenschaltungselement bilden und
wobei an den Enden des Reihenschaltungselements (13) dritte, flexible Elektroden (3c) vorgesehen sind,
ferner umfassend:
eine erste Deckschicht (4), die zum Abdecken der ersten Elektroden (3a) vorgesehen ist, und zwar in solcher Weise, dass die ersten Elektroden (3a) darin vergraben sind, und
eine zweite Deckschicht (5), die zum Abdecken der dritten Elektroden (3c), der thermoelektrischen Umwandlungselemente (2a, 2b) und der zweiten Elektroden (3b) vorgesehen ist, und zwar in solcher Weise, dass diese darin vergraben sind,
wobei die erste Deckschicht (4) und die zweite Deckschicht (5) ein Material enthalten, das als wärmeleitendes Material fungiert, und wobei die zweite Deckschicht (5) eine geringere Wärmeleitfähigkeit aufweist als die erste Deckschicht (4).

2. Thermoelektrisches Umwandlungsmodul (1) nach Anspruch 1, mit einer Mehrzahl der Reihenschaltungselemente (13), wobei die Reihenschaltungselemente (13) durch die dritten Elektroden (3c) miteinander verbunden sind.

3. Thermoelektrisches Umwandlungsmodul (1) nach Anspruch 1 oder 2, wobei die dritte Elektrode (3c) ein Metallgitter umfasst.

4. Thermoelektrisches Umwandlungsmodul (1) nach Anspruch 3, wobei die dritte Elektrode (3c) Metallplatten enthält, die an dem Metallgitter an gegenüberliegenden Enden befestigt sind.

5. Thermoelektrisches Umwandlungsmodul (1) nach einem der Ansprüche 1 bis 4, wobei die ersten und die zweiten Elektroden (3a, 3b) flexibel sind.

## Revendications

1. Module de conversion thermoélectrique (1), comprenant
une pluralité d'éléments de conversion thermoélectrique (2a, 2b) agencés adjacents les uns aux autres,
des premières électrodes (3a) reliées à des premières extrémités des éléments de conversion thermoélectrique (2a, 2b) pour connecter électriquement les premières extrémités d'éléments de conversion thermoélectrique (2a, 2b) adjacents, et
des deuxième électrodes (3b) reliées à des deuxièmes extrémités, opposées, des éléments de conversion thermoélectrique (2a, 2b) pour connecter électriquement les deuxièmes extrémités d'éléments de conversion thermoélectrique (2a, 2b) adjacents, où
les éléments de conversion thermoélectrique (2a, 2b) connectés électriquement par les premières et deuxièmes électrodes (3a, 3b) forment au moins un élément de circuit en série, et
des troisième électrodes (3c) ayant une flexibilité sont prévues à des extrémités de l'élément de circuit en série (13),
comprenant en outre :
une première couche de couverture (4) prévue pour couvrir les premières électrodes (3a) de manière à ce que les premières électrodes (3a) y soient enfouies, et
une deuxième couche de couverture (5) prévue pour recouvrir les troisièmes électrodes (3c), les éléments de conversion thermoélectrique (2a, 2b), et les deuxièmes électrodes (3b) de manière à ce qu'ils y soient enfouis,
dans lequel la première couche de couverture (4) et la deuxième couche de couverture (5) contiennent un matériau fonctionnant en tant que matériau thermo-conducteur, et dans lequel la deuxième couche de couverture (5) a une conductivité thermique inférieure à celle de la première couche de couverture (4).

2. Module de conversion thermoélectrique (1) selon la revendication 1, comprenant une pluralité d'éléments de circuit en série (13), dans lequel
les éléments de circuit en série (13) sont connectés entre eux par les troisièmes électrodes (3c).

3. Module de conversion thermoélectrique (1) selon la revendication 1 ou 2, dans lequel la troisième électrode (3c) comporte un treillis métallique.

4. Module de conversion thermoélectrique (1) selon la revendication 3, dans lequel la troisième électrode (3c) comporte des plaques métalliques fixées au treillis métallique à des extrémités opposées.

5. Module de conversion thermoélectrique (1) selon l'une quelconque des revendications 1 à 4, dans lequel les premières et deuxièmes électrodes (3a, 3b) ont une flexibilité.
